# EUROPEAN PATENT APPLICATION

(11) **EP 3 609 305 A1**
(43) Date of publication of application: **12.02.2020**
(21) Application number: 19190921.7
(22) Date of filing: 09.08.2019
(51) Int. Cl.: H05K 7/14

(54) **ASSEMBLY WITH PRINTED CIRCUIT BOARD AND METHOD OF FIXING A PRINTED CIRCUIT BOARD**

(30) Priority: 10.08.2018 IN 201841030095
(71) Applicant: TE Connectivity Germany GmbH, 64625 Bensheim (DE); TE Connectivity India Private Limited, Bangalore 560048 (IN)
(72) Inventor: Riedl, Gerhard, 76297 Stutensee-Friedrichsthal (DE); Schulz, Alexander, 67459 Boehl-lgge/Heim (DE); Kraemer, Christoph, 68163 Mannheim (DE); Steeg, Oliver, 68623 Lampertheim (DE); Singh, Kiranpal, 560037 Bangalore (IN); Geisselmann, Bernd, 67346 Speyer (DE)
(74) Representative: Johnstone, Douglas Ian

(57) **Abstract**

A housing assembly (100) with a printed circuit board (103), and to a method of fixing the printed circuit board (103) in the housing assembly (100). An assembly (100) comprises a first housing portion (101) having a first retaining element (102) extending upwards from a base (111) of the first housing portion; a second housing portion (104) having a second retaining element (109) extending downwards from a cover (120) of the second housing portion (104); a printed circuit board (103), attachable to an open end of the first retaining element (102); wherein the open end of the first retaining element (102) is adapted to receive a distal end of the second retaining element (109) when the first housing portion (101) engages with the second housing portion (104).

## Description

The present disclosure relates to a housing assembly with a printed circuit board, and to a method of fixing the printed circuit board in the housing assembly.

A printed circuit board (PCB), which is also referred to as a printed wiring board (PWB), is used primarily to create a connection between components, such as resistors, integrated circuits, and connectors. It becomes an electrical circuit when components are attached and soldered to it, which then is called a printed circuit board assembly (PCBA). Printed circuit board assemblies are commonly composed of a similar set of basic elements. These comprise electronic components that perform the intended circuit functions, a printed circuit board that supports components and provides interconnections between them, one or more connectors that are used as an electrical interface between the printed circuit board assembly, and the rest of the system and mechanical parts for mounting parts and hardware to the board, attaching the PCB to the system, providing thermal paths and supporting and stiffening the assembly.

PCBs are very sensitive to environmental conditions. Depending on the device type in which a PCB is utilized, different requirements come into existence, such as mechanical integrity of a system, durability against thermal or vibrational loading and prevention of electromagnetic interference (EMI). In order to meet such requirements, PCBs are mounted onto frames or into box-like structures.

Electronic boxes are usually composed of one or more covers and a body where printed circuit boards are mounted. Printed circuit boards are the most frequently used interconnection technology for components in electronic products. The requirements of PCBs have developed with the increase in the packaging density of modern electronic and mechanical components. Such requirements now include finer conductor tracks and thinner laminates that are present in an ever-increasing number of layers. Integrated circuits (IC) have become dramatically sophisticated especially in the last decade. This has in turn created new design and fabrication requirements for mounting them onto the boards.

PCBs are usually connected to an electronic box by screws or so called card-lock retainers. Screws occupy less space on a PCB compared to card-lock retainers. However, it has been found that the more rigid connections that offered by card-lock retainers especially for larger PCBs, are needed.

These requirements have led to a rising trend in the implementation of fixation of the PCBs. PCBs have higher functionality/density, improved reliability and lower cost through better and more tightly controlled/cost-effective processing. Furthermore, the advantages in contract manufacturing at the global level effectively ensures that the design and manufacture of PCBs are of internationally accepted quality. Printed Circuit Boards may be classified according to their various attributes. A more simple and understandable classification is used nowadays, which is based on the number of planes or layers of wiring, which constitute the total wiring assembly or structures, and to the presence or absence of plated-through holes. This method of classifying boards has the advantage of being related directly to the board specifications.

The PCB fabrication process involves a number of mechanical operations to prepare the circuit boards. The process starts with the acquisition of laminate sheets which may be as big as 2 m x 2 m or greater. Therefore, the mechanical process such as cutting to size, drilling holes and shaping play an important role in the final quality of the printed circuit board. Unlike other PCB processing steps, most of the mechanical operations require considerable manual handling of the board. Each mechanical operation has its own set of requirements in terms of tolerance and accuracy. In general, tolerances should be made as narrow as they are functionally really needed. Proper choice of tools and their sharpness are very important in each of the mechanical operations for obtaining an acceptable machining finish. Blunt and dull tools result in chipping because of resin brittleness of the laminate. Proper application of machining forces must be kept low. Excessive machining forces may cause partial de-lamination because of the inherent laminate structure, thereby weakening the interlaminar bond strength.

Vibration is one of the most important loading conditions in electronic systems. Along with the rapid development of the microelectronic industry, the wide application of high density assembly and the more severity of the service environment of electronic product, the micro-assembly devices usually confront different vibration and shock environment effects, which can increase elastic-plastic deformation and creep deformation, and make fatigue damage rapidly cumulative. This can lead to failure of the PCB Assembly, so the reliability becomes more and more important. Thus, the point, which we cannot ignore, is that the chips under vibration environment will create fatigue failure. Electronic assemblies are formed by electronic components attached to the PCBs which are mounted into the electronic boxes. Therefore, vibration analysis of an electronic system is usually handled in three main levels: (i) electronic box, (ii) printed circuit board, and (iii) electronic components.

In the prior art numerous methods for fixing functional components in a housing are known, for example, with positive interlock, friction force retention, material-integral bonding, or combinations of these. Some of these methods involve numerous process steps and, to that extent, entail long tolerance chains.

For example, in the prior art, a method is known for fixing a functional component in a housing. During a first step, a first housing portion is prepared in which a functional component, to be fixed, is arranged in a provisional fixing position. During a second step, a second housing portion is brought into contact with the first housing portion so that the functional component is arranged in a joining direction (X) between the housing portions. During a third step, material from at least one of the housing portions is melted in such a manner that the functional component, located between the housing portions, is gripped into position when a material-integral bond is formed between the housing portions. Such a method is described in the document US9073149. In this document a larger number of processing steps are required to fix the functional component. Furthermore, the gripping of the functional component is solely based on the attachment of the first housing portion with the second housing portion. Such a gripping cannot withstand the vibrational shocks that the housing will experience, for example in a vehicle.

Another method is described in the document US8759710, wherein a process is described for form locking joining of two components through plastic deformation of one of the two components. In order for the tool for forming the form locking connection not to get in direct contact with the plasticized area of the joining partners, a third component between the tool and the two components to be joined through form locking is being used, which simultaneously enters into an adhesive bond with one of the two components to be joined through form locking. The thermal energy for creating the plastic state of one of the joining partners and for developing the adhesive bond is applied through electromagnetic radiation through the third component. This prior art document solely relates to the joining of the two components and no disclosure is made as to how the joining of the two components can fix the PCB. Similar methods for joining parts of components are also described in the document US9030835.

Several studies are related to different vibration problems occurring in electronic systems. These researches have different objectives, such as understanding the vibration phenomenon in electronic systems, vibration isolation, life prediction of solder joints and reliability calculations. Analytical methods for analyzing vibration in electronic assemblies conclude that failures in electronic equipment mostly depend on mechanical loading, and these mechanical failures are mainly observed in component lead wires and solder joints.

Thus, a need exists for a method providing a robust fixation of the PCB in the housing to withstand the stresses caused, for example, by vibrational or torsional motion.

The present disclosure overcomes the limitations of the prior art document by proposing a method for fixing the PCB in a housing entailing fewer steps and at the same time increasing the robustness of the fixed PCB. Starting from there, the present disclosure proposes a method for fixing a printed circuit board in a housing and an arrangement obtained therefrom, which overcome the drawbacks of the prior art and so enables simple, substantially robust fixing with comparatively fewer process steps and hence lower costs.

The object is solved by the subject matter of the independent claims. Advantageous embodiments of the invention are the subject matter of the dependent claims.

According to an advantageous embodiment of the present disclosure, an assembly for housing a PCB is provided. The assembly comprises a first housing portion having at least one first retaining element extending upwards from a base of the first housing portion and a second housing portion having at least one second retaining element extending downwards from a cover of the second housing portion, towards the first housing portion, wherein the open end of the first retaining element is adapted to receive a distal end of the second retaining element when the first housing portion engages with the second housing portion.

According to an advantageous embodiment of the present disclosure, the engagement of the first housing portion with the second housing portion in the assembly is effected through laser welding.

According to an advantageous embodiment of the present disclosure, the open end of the first retaining element in the assembly is segmented and may be in the form of a rosette.

According to an advantageous embodiment of the present disclosure, the first retaining element in the assembly has a form of a hollow cavity.

According to an advantageous embodiment of the present disclosure, a PCB in the assembly is attachable to an open end of the first retaining element.

According to an advantageous embodiment of the present disclosure, the second retaining element in the assembly preferably has a shape of a conical mandrel with a converging end suitable to be received in the hollow cavity without touching the base of the hollow cavity.

According to an advantageous embodiment of the present disclosure, approximately two-thirds of a length from the open end of the first retaining element is segmented.

According to an advantageous embodiment of the present disclosure, the segments of the first retaining element creep or distort onto the PCB when the first housing portion engages with the second housing portion.

According to an advantageous embodiment of the present disclosure, the first retaining element tapers towards the base when the first housing portion engages with the second housing portion.

According to an advantageous embodiment of the present disclosure, an electronic assembly comprising a housing assembly according to the present disclosure is provided.

According to an advantageous embodiment of the present disclosure, a method for fixing a PCB in a housing is provided. The method comprises the steps of aligning a first housing portion having a first retaining element extending upwards from a base of the first housing portion with a second housing portion having a second retaining element extending downwards or towards the first housing portion from a cover of the second housing portion, wherein the PCB is attachable to an open end of the first retaining element and laser welding the cover of the second housing portion with the first housing portion, wherein the open end of the first retaining element is segmented forming a rosette, and wherein the first retaining element has a form of a hollow cavity, preferably a hollow cylinder.

According to an advantageous step of the method of the present disclosure, the walls of the first housing portion is laser welded with the cover of the second housing portion.

According to an advantageous step of the method of the present disclosure, a radial force generated by the laser welding fixes the PCB.

According to an advantageous step of the method of the present disclosure, the second retaining element has a shape of a conical mandrel with a converging end suitable to be received in the hollow cavity without touching the base of the hollow cavity.

According to an advantageous step of the method of the present disclosure, the segments of the first retaining element creep or distort onto the PCB when the first housing portion engages with the second housing portion.

In the following, the invention is described in more detail with reference to the attached figures and drawings. Similar or corresponding details in the figures are marked with the same reference numerals.

The accompanying drawings are incorporated into the specification and form a part of the specification to illustrate several embodiments of the present invention. These drawings, together with the description, serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form, individually or in different combinations, solutions according to the present invention. The following described embodiments can thus be considered either alone or in an arbitrary combination thereof. The described embodiments are merely possible configurations, and it must be borne in mind that the individual features, as described above, can be provided independently of one another, or can be omitted altogether while implementing this invention. Further features and advantages will become apparent from the following, more particular description of the various embodiments of the invention, as illustrated in the accompanying drawings in which like references refer to like elements, and wherein:
Fig. 1 shows as an example, a cross-section of an arrangement of an assembly with the PCB to be fixed;
Fig. 2 shows a cross-sectional top view of the segmented first retaining element upon the PCB;
Fig. 3 shows a perspective top view of the segmented first retaining element;
Fig. 4 shows as an example of a cross-section of an alternative arrangement of an assembly with the PCB to be fixed;
Fig. 5 shows a cross-sectional top view of the segmented first retaining element upon the PCB in the alternative arrangement;
Fig. 6 shows a cross-sectional side view of a further example of an assembly according to the present invention before performing a welding step;
Fig. 7 shows the assembly of Fig. 6 after the welding has been performed.

The present invention will be explained in more detail with reference to the drawings.

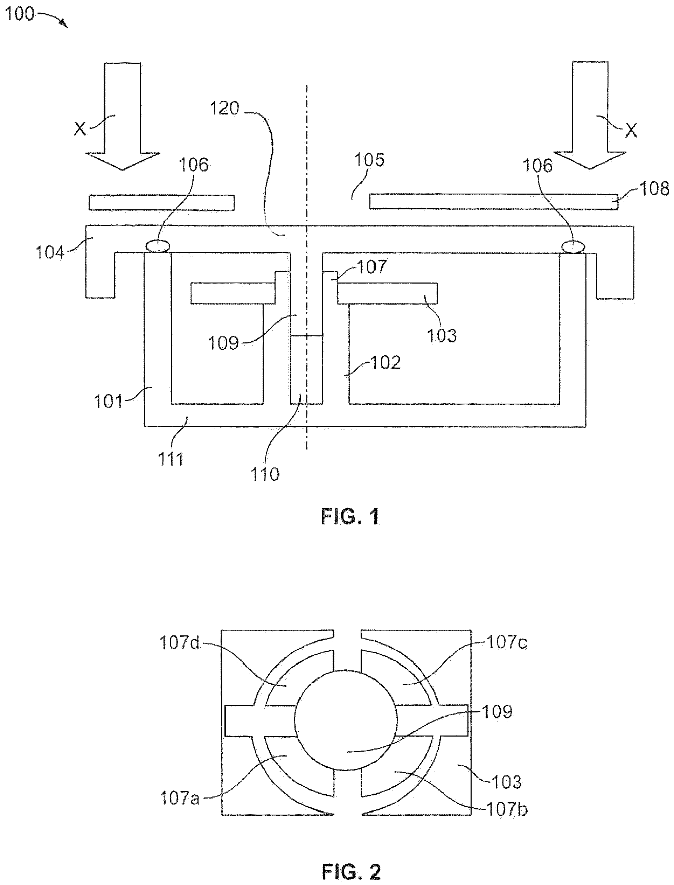

As an example, Figure 1 shows an assembly 100 for implementing the method according to the present disclosure. The assembly comprises of a first housing portion 101, a printed circuit board 103, and a second housing portion 104. The first 101 and the second 104 housing portions are joined by means of laser welding, and as a result of a joining process, fix the printed circuit board. An assembly that can be made according to the present disclosure by the first housing, the second housing and the PCB, which serves for example, to accommodate and fix the PCB, in particular, for its protection, for example against environmental influences, aggressive media and mechanical effects is provided.

Accordingly, an effort is made to make the housing impermeable to gases, liquids or other media for example, and to make it as strong as necessary for example in the case of sensor housings intended for use in harsh surroundings. By means of a material-integral bonding process, besides joining the joint partners the necessary impermeability and strength can also be achieved. The housing portions 101 and 104 can, as an example, be made of plastic or metal or other suitable materials, and it is also conceivable for first and second housing portions to comprise different materials.

In the housing, the PCB 103 is to be accommodated and fixed as positionally accurate as possible, for example in such manner that it can be secured against slipping or rattling, and is not affected by tolerances. Furthermore, the PCB 103 should be held in an exact position, such as a specified distance away from the base of the first housing portion 101 or the cover of the second housing portion 104. To achieve such permanent fixing, in particular positionally accurate fixing unaffected by tolerances, and according to the present disclosure, a first step aligns a first housing portion 101 having a first retaining element 102 extending upwards from a base 111 of the first housing portion with a second housing portion 104 having a second retaining element 109 extending downwards from a cover 120 of the second housing portion, wherein the PCB 103 is removably attached to an open end of the first retaining element 102. The PCB 103 is arranged in the first housing portion 101 in a provisional fixing position, although the term 'provisional fixing position' relative to the first housing portion 101, where the PCB is placed in the first step, can also refer to a final, specified fixing position. The open end of the first retaining element is adapted to receive a distal end of the second retaining element 109 when the first housing portion 101 engages with the second housing portion 104.

The second retaining element 109 (which may also be referred to as a dome) may have a slightly tapered (i, e. conical) shape in order to facilitate introducing the second retaining element 109 between the segments of the segmented portion 107.

For this purpose the first retaining element 102 attached to the base 111 of the first housing portion 101 is in the form of a hollow cavity 110, preferably having a cylindrical shape. The end of the first retaining element 102 distal to the base 111 of the first housing portion 101 is segmented as shown in detail in Figure 2.

For example, the four segmented portions 107a, 107b, 107c, 107d are shown in Figure 2 for illustrating the method of the present disclosure. These segmented portions are symmetrically arranged having a shape of a rosette around the central axis of the first retaining element 102. Approximately two-thirds of the length from the open end of the first retaining element 102 is segmented. Thus, the PCB 103 is positioned sufficiently below the open end of the first retaining element 102. The second retaining element 109 preferably has a shape of a conical mandrel with a converging end suitable for receipt in the hollow cavity 110 without touching the base of the hollow cavity 110.

When the second housing portion 104 is aligned with the first housing portion 101, the second retaining element 109 on the cover of the second housing portion 104 is received in the hollow cavity 110 of the first retaining element 102 attached to the base of the first housing portion 101. The second retaining element passes through the segmented portion 107a-107d. After the alignment of the first housing portion 101 with the second housing portion 103, the two housing portions are laser welded at points 106 as shown in Figure 1. This laser welding creates a force sufficient to push the second retaining element 109 into the hollow cavity 110 of the first housing portion 102. Moreover, in the finally mounted state, the segmented portion 107 does not touch the second housing portion 104.

Optionally, the laser impinges a glass plate 108 above the cover of the second housing portion 104 in a direction X as shown in Figure 1.

The glass plate 108 is transparent to the laser beam. This further enhances the pressure for laser welding for joining two housing portions. Preferably, the glass plate 108 has an opening 105 adjacent to the region of the second housing portion 104, where the second retaining element 109 is located. This opening has the advantage that the second retaining element 109 works itself into the cavity 110 against the mechanical spreading resistance of the segmented portion 107. Thereby, a force vector can be achieved in the finally mounted state that is directed towards the inside (along the direction X) and is larger than the forces occurring during operation caused by the inner pressure under heating, or by vibration. Consequently, over its entire operational life, the PCB 103 will not be lifted from the seat area at the first retaining element 102.

While sliding into the cavity 110, the second retaining element 109 exerts a force on the segmented portions 107a-107d at the open end of the first retaining element 102. This force acts in the radial direction on the segmented ends 107a-107d of the first retaining element 102 and causes them to creep onto the PCB 103. Thus, the PCB is fixed in the housing.

The fixing of the PCB 103 according to the present disclosure assures that robustness of the fixation is immune to the vibrational and torsional stresses that the housing with fixed PCB will experience in use. The radially disposed segmented ends 107a-107d of the open end of the first retaining element 102 on the PCB 103, defines an optimal geometry that dissipates the mechanical and vibrational stresses that the housing experiences in operation. For instance, electronic components in vehicles are subjected to shock and vibration environments. The components must be designed accordingly. The arrangement of the PCB according to the present disclosure results in lower fatigue limits than those of arrangements of the electronic components presented in the prior art.

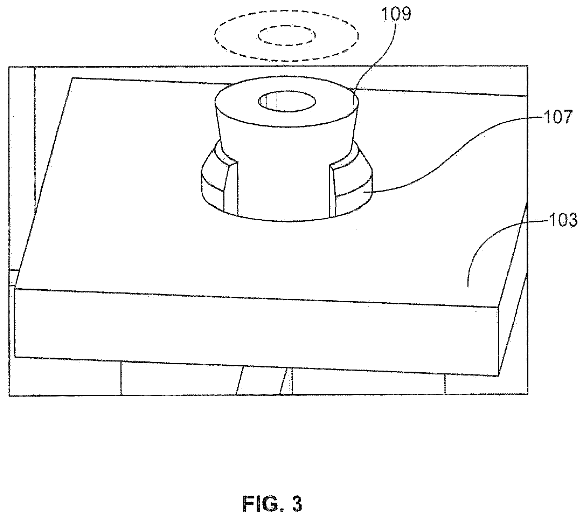

Figure 3 shows a perspective top view of the segmented first retaining element 107a-107d. This figure shows clearly that the second retaining element 109 engages with the first retaining element 102 passing through the segmented portions 107a-107d of the first retaining element 102. The force created by the laser welding on the cover of the second housing portion 104 pushes the second retaining element 109 inside the first retaining element 102. In doing so, the segmented portions 107a-107d creep upon or are displaced towards the PCB thus fixing the PCB in the housing. The segmentation of the end of the first retaining element 102 causes the exposure to the vibrational stresses to dissipate without moving the PCB from its fixed position.

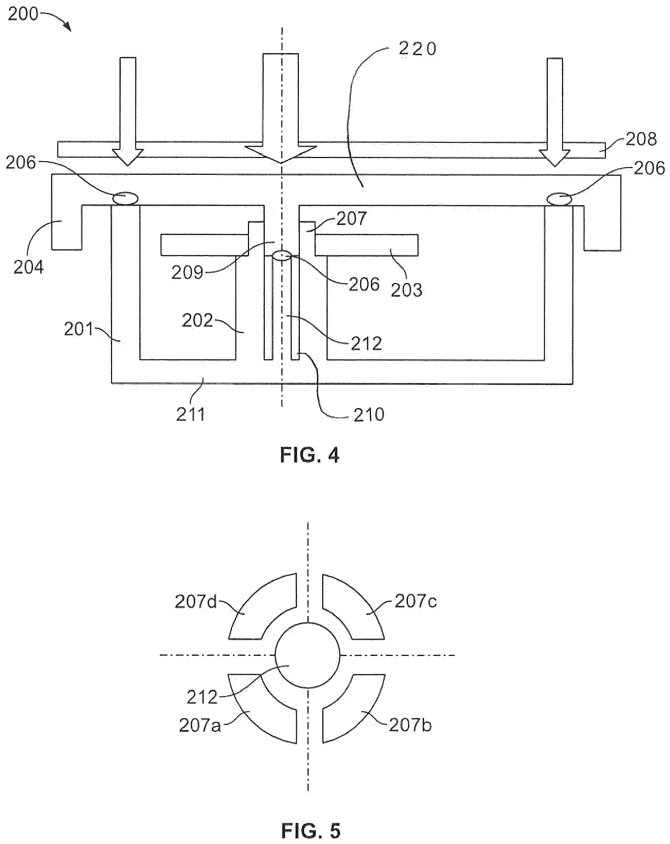

Figure 4 and Figure 5 show an alternative embodiment of the present disclosure. The only differences to the previous embodiment as shown in Figures 1, 2, and 3 are described in the following. Otherwise, full reference is made to the preceding text.

The cover 220 of the housing portion 204 is laser welded additionally at the junction of the second retaining element with the first retaining element. The first retaining element 202 comprises a central dome or column 212 to effect this welding 206. It is to be noted that in this arrangement also, it is the creeping of the segmented portions 207a-207d that fixes the PCB in the housing. The additional welding point only serves to enhance the force with which the cover pushes the second retaining element onto the first retaining element. The creeping of the segmented portion of the first retaining element is caused by the force exerted by the second retaining element on the first retaining element. Moreover, in the finally mounted state, the segmented portion 207 does not touch the second housing portion 204.

It is to be noted that the arrangement of the housing, according to the present disclosure, is designed taking into consideration the dynamic behavior of the housing under vibration loading. Excitation is transmitted to the printed circuit board by passing through base of the first housing portion. As such, the creeping of the segmentation of the open end of the first retaining element attached to the base of the first housing portion assures that the vibrational loading is dampened, and the PCB does not move from its fixed position.

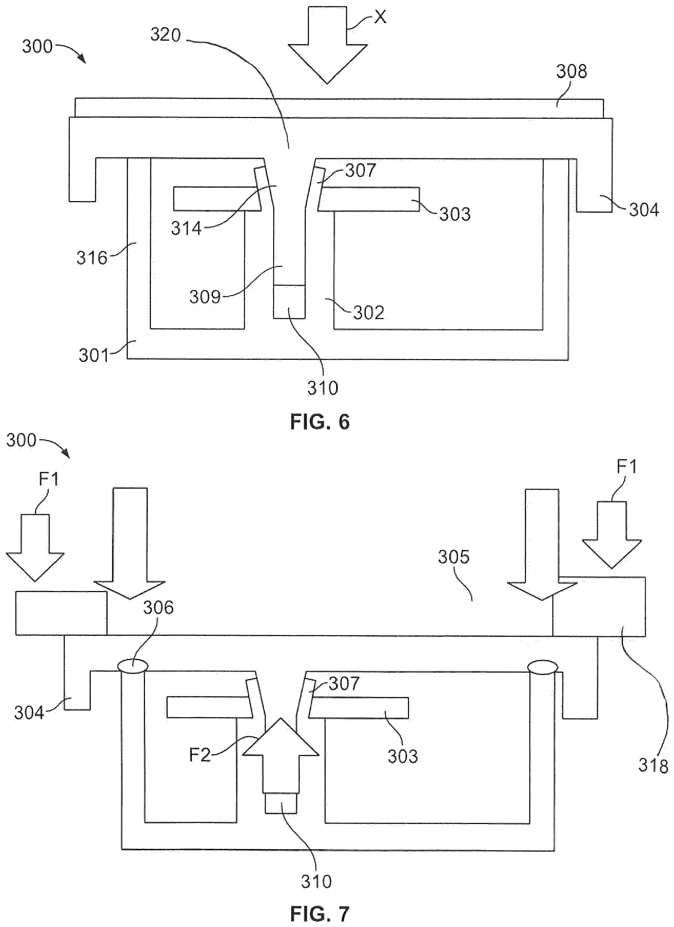

Figures 6 and 7 show a further advantageous example of an assembly according to the present disclosure during assembly. The arrangement corresponds to the first example shown in Figures 1 and 2, except for the shape of the second retaining element 309. According to this improvement, the second retaining element 309 has a conical section 314, which engages with the segmented portion 307. Thereby, the individual segments 307a-307d are forced apart more effectively. Figures 6 and 7 illustrate two assembly steps according to this embodiment. As shown in Figure 6, the second housing portion 304 (which may also be referred to as a cover 320) is aligned with the first housing portion 301. A first plate 308 (for instance fabricated from glass) is pressed in the direction X, until a sidewall 316 blocks the further movement of the cover.

In a next step, which is illustrated in Fig. 7, the mechanical pressure is further enhanced by pressing on a second plate 318 for performing the laser welding (as indicated by the force arrows F1). The second plate 318 may for instance by formed from glass or any other suitable material. This additional pressure leads to an enhanced radial force acting on the segmented portion 307 as indicated by the force arrow F2. The second plate 318 advantageously has an opening 305 in the vicinity of the second retaining element 309.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first retaining element, component, region, layer or section discussed below could be termed a second retaining element, component, region, layer or section without departing from the teachings of the present disclosure.

Spatially relative terms, such as "proximal", "distal", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90° or at other orientations), and the spatially relative descriptors used herein interpreted accordingly.

As used herein, the singular forms "a", "an" and "the" are intended to include the plural forms as well, unless expressly stated otherwise. It will be further understood that the terms "includes," "comprises," "including" and/or "comprising," when used in this specification, specify the presence of stated features, integers, steps, operations, elements, and/or components, but do not preclude the presence or addition of one or more other features, integers, steps, operations, elements, components, and/or groups thereof. It will be understood that when an element is referred to as being "connected" or "coupled" to another element, it can be directly connected or coupled to the other element or intervening elements may be present. As used herein, the term "and/or" includes any and all combinations of one or more of the associated listed items.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of this specification and the relevant art, and will not be interpreted in an idealized or overly formal sense unless expressly so defined herein,

It is to be understood that the above description is intended to be illustrative, and not restrictive. For example, the above-described embodiments (and/or aspects thereof) may be used in combination with each other. In addition, many modifications may be made to adapt a particular situation or material to the teachings of the invention without departing from its scope. Dimensions, types of materials, orientations of the various components, and the number and positions of the various components described herein are intended to define parameters of certain embodiments, and are by no means limiting and are merely example embodiments. Many other embodiments and modifications within the scope of the claims will be apparent to those of ordinary skill in the art upon reviewing the above description. The scope of the invention should, therefore, be determined with reference to the appended claims, along with the full scope of equivalents to which such claims are entitled. In the appended claims, the terms "including" and "in which" are used as the plain-English equivalents of the respective terms "comprising" and "wherein." Moreover, in the following claims, the terms "first," "second," and "third," etc. are used merely as labels, and are not intended to impose numerical requirements on their objects.

While the present disclosure has been particularly shown and described with reference to exemplary embodiments thereof, it will be understood by those skilled in the art that various changes in form and details may be made therein without departing from intent of the disclosure as defined by the appended claims. The exemplary embodiments should be considered in descriptive sense only, and not for purposes of limitation. Therefore, the scope of the present disclosure is defined not by the above description of the invention, but by the appended claims, and all differences within the scope will be construed as being included in the present invention.

**REFERENCE NUMERALS**

| **Reference numeral** | **Description** |
|---|---|
| 100, 200, 300 | Assembly |
| 101, 201, 301 | First housing portion |
| 102, 202, 302 | First retaining element |
| 103, 203, 303 | PCB |
| 104, 204, 304 | Second housing portion |
| 105, 305 | Opening |
| 106, 206, 306 | Laser welding points |
| 107/107a-107d 207/207a-207d | Segmented portion/segments |
| 108, 208, 308 | First (glass) plate |
| 109, 209, 309 | Second retaining element |
| 110, 210, 310 | Cavity |
| 111, 211 | Base of first housing portion |
| 212 | Central dome/column |
| 314 | Conical section |
| 316 | Sidewall |
| 318 | Second plate |
| 120, 220, 320 | Cover |

## Claims

1. An assembly (100, 200) for housing a printed circuit board (103, 203), comprising
a first housing portion (101, 201) having at least one first retaining element (102, 202) extending upwards from a base (111, 211) of the first housing portion (101, 201);
a second housing portion (104, 204) having at least one second retaining element (109, 209) extending downwards from a cover (120, 220) of the second housing portion (104, 204), towards the first housing portion (101, 201),
wherein an open end of the first retaining element (102, 202) is adapted to receive a distal end of the second retaining element (109, 209) when the first housing portion (101, 201) engages with the second housing portion (104, 204).

2. The assembly (100, 200) according to claim 1, wherein the engagement of the first housing portion (101, 201) with the second housing portion (101, 201) is effected through laser welding (106, 206).

3. The assembly (100, 200) according to claim 1 or 2, wherein the open end of the first retaining element (102, 202) is segmented forming a rosette.

4. The assembly (101, 201) according to any preceding claim, wherein the first retaining element (102, 202) has a hollow cavity (110, 210).

5. The assembly (101, 201) according to any preceding claim, wherein the printed circuit board (103, 203), is attachable to an open end of the first retaining element (102, 202).

6. The assembly (101, 201) according to any preceding claim, wherein the second retaining element (109, 209) has a shape of a conical mandrel with a converging end suitable to be received in a hollow cavity (110, 210) without touching the base of the hollow cavity (110,210).

7. The assembly (101, 201) according to any preceding claim, wherein approximately two-thirds of a length of the first retaining element (102, 202) from the open end of the first retaining element (102, 202) is segmented.

8. The assembly (101, 201) according to any preceding claim, wherein segments (207, 307) of the first retaining element (102, 202) creep onto the printed circuit board (103, 203) when the first housing portion (101, 201) engages with the second housing portion (102, 202).

9. The assembly (101, 202) according to any preceding claim, wherein the first retaining element (102, 202) tapers towards the base (111, 211) when the first housing portion (102, 202) engages with the second housing portion (104, 204).

10. An electronic assembly comprising a housing assembly according to any of the claims 1 to 9.

11. A method for fixing a printed circuit board (103, 203), in a housing (101, 104; 201, 204), the method comprising the steps of
aligning a first housing portion (101, 201) having a first retaining element (102, 202) extending upwards from a base (111, 211) of the first housing portion (102, 201) with a second housing portion (104, 204) having a second retaining element (109, 209) extending towards the first housing portion (101, 201) from a cover (120, 220) of the second housing portion (104, 204), wherein the printed circuit board (103, 203) is attachable to an open end of the first retaining element (102, 202),
laser welding (106, 206) the cover (120, 220) of the second housing portion (104, 204) to the first housing portion (101, 201), wherein the open end of the first retaining element (102, 202) is segmented forming a rosette, and wherein the first retaining element (102, 202) has a form of a hollow cavity (110, 210) preferably a hollow cylindrical cavity.

12. The method according to claim 11 wherein walls of the first housing portion (101, 201) are laser welded (106, 206) to the cover (120, 220) of the second housing portion (104, 204),

13. The method according to claim 11 or 12 wherein a radial force generated by the laser welding (106, 206) fixes the printed circuit board (103, 203).

14. The method according to claim 11, 12 or 13 wherein the second retaining element (109, 209) has a shape of a conical mandrel with a converging end suitable to be received in the hollow cavity (110, 210) without touching a base of the hollow cavity (110, 210).

15. The method according to any of claims 11 to 14 wherein segments (107a-d, 207a-d) of the first retaining element (102, 202) creep onto the printed circuit board when the first housing portion (101, 201) engages with the second housing portion (104, 204).
